# EUROPÄISCHE PATENTANMELDUNG

(11) **EP 0 618 623 A2**
(43) Veröffentlichungstag der Anmeldung: **05.10.1994**
(21) Anmeldenummer: 94103123.9
(22) Anmeldetag: 02.03.1994
(51) Int. Cl.: H01L 31/0224, H01L 31/0352, H01L 31/18, H01L 27/142

(54) **Verfahren zur Herstellung einer Solarzelle aus einer Substratscheibe**

(30) Priorität: 29.03.1993 DE 4310206
(71) Anmelder: SIEMENS AKTIENGESELLSCHAFT, D-80333 München (DE)
(72) Erfinder: Lehmann, Volker, Dr., D-80689 München (DE); Willer, Josef, Dr., D-85521 Riemerling (DE); Hönlein, Wolfgang, Dr., D-82008 Unterhaching (DE)

(57) **Zusammenfassung**

In einer Substratscheibe werden durch elektrochemisches Ätzen durchgehende Löcher (4) gebildet, so daß eine perforierte, freitragende Schicht (7) aus n-dotiertem, monokristallinem Silizium entsteht. In der freitragenden Schicht (7) werden ein n-dotiertes Gebiet (10, 13) und ein p-dotiertes Gebiet (9) hergestellt, die einen pn-Übergang bilden und die beide an eine erste Hauptfläche (2) der freitragenden Schicht (7) angrenzen. Auf der ersten Hauptfläche (2) wird ein Kontakt (15) zu dem n-dotierten Gebiet (13, 10) und ein Kontakt (14) zu dem p-dotierten Gebiet (9) gebildet, so daß der pn-Übergang als Solarzelle verschaltbar ist, in die der Lichteinfall über eine zweite, der ersten gegenüberliegenden Hauptfläche (52) erfolgen kann.

## Beschreibung

Zur Herstellung von Solarzellen werden unter anderem Substratscheiben aus monokristallinem Silizium verwendet. Die daraus hergestellten monokristallinen Solarzellen sind anderen, auf der Basis von polvkristallinem oder amorphem Silizium hergestellten bezüglich Wirkungsgrad und Langzeitstabilität überlegen.

Bei monokristallinen Solarzellen befindet sich gewöhnlich je ein elektrischer Kontakt auf jeder Seite. Der Lichteinfall erfolgt dabei durch eine Oberfläche, an der ein Kontakt angeordnet ist (s. z. B. R. Müller, Bauelemente der Halbleiterelektronik, Springer Verlag 1979, Seite 45 bis 47).

Da ein Kontakt auf der dem Licht zugewandten Oberfläche der Solarzelle angeordnet ist, wird ein Teil dieser Oberfläche abgeschattet. Dieses hat einen geringeren Gesamtwirkungsgrad der Solarzelle zur Folge.

Um diese Ahschattung gering zu halten, wird der Kontakt auf der dem Licht zugewandten Oberfläche z. B. kammartig strukturiert. Dadurch wird der Leitungsquerschnitt des Kontaktes minimal gehalten. Damit sind jedoch erhöhte ohmsche Verluste verbunden, die wiederum zu einer Beeinträchtigung des Wirkungsgrads fuhren.

Mehrere Solarzellen dieses Typs können, da die elektrischen Kontakte jeweils auf gegenüberliegenden Seiten angeordnet sind, nur durch Zuhilfenahme eines leitfähigen Verbindungselementes, z. B. eines Drahtes, verschaltet werden. Dazu muß ein gewisser Abstand zwischen benachbarten Solarzellen eingehalten werden, damit das Verbindungselement auf die Rückseite der benachbarten Zelle gefuhrt werden kann. Dadurch kann eine zur Verfügung stehende Fläche nicht beliebig dicht mit Solarzellen belegt werden.

In K. Fukui et al, Techn. Dig. of 4th Sunshine Workshop on Crystalline Solar Cells (1992), Chiba, Japan, S. 25 - 29, ist eine Solarzelle vorgeschlagen worden, die in einem Abstand von 150 µm angeordnete durchgehende Löcher von der Vorderzur Rückseite der Solarzelle aufweist. Die Solarzelle ist aus p-dotiertem Silizium hergestellt. An der Vorderseite der Solarzelle und entlang der Oberfläche der Löcher weist die Solarzelle einen n-dotierten Bereich auf. Von der Rückseite her werden der n-dotierte Bereich durch n-Kontakte und der p-dotierte Bereich durch p-Kontakte angeschlossen. Derartige durchgehende Löcher durch Siliziumsubstrate lassen sich insbesondere mit Hilfe eines Lasers herstellen. Dabei muß jedes Loch separat erzeugt werden.

Der Erfindung liegt das Problem zugrunde, ein Verfahren zur Herstellung einer Solarzelle aus einer Substratscheibe anzugeben, mit dem eine Kontaktierung der Solarzelle von der Rückseite her ermöglicht wird und das für den großtechnischen Einsatz geeignet ist.

Dieses Problem wird erfindungsgemäß gelöst durch ein Verfahren nach Anspruch 1. Weitere Ausgestaltungen der Erfindung gehen aus den übrigen Ansprüche hervor.

In dem erfindungsgemäßen Verfahren ist es durch Verwendung einer perforierten, freitragenden Schicht aus n-dotiertem, monokristallinem Silizium möglich, das n-dotierte Gebiet und das p-dotierte Gebiet von derselben Seite her über die erste Hauptfläche zu kontaktieren. Dazu wird insbesondere die gesamte Oberfläche der freitragenden Schicht mit einer p-Dotierung versehen. Das n-dotierte Gebiet wird dabei durch das Innere der freitragenden Schicht gebildet, das weiterhin n-dotiert ist. In einem Bereich der ersten Hauptfläche, in dem der Kontakt zu dem n-dotierten Gebiet entstehen soll, wird dann die p-dotierte Oberfläche selektiv, z. B. unter Zuhilfenahme einer Maske, abgeätzt, bis in diesem Bereich das n-dotierte Gebiet freiliegt, das dann mit einem Kontakt versehen wird.

Die elektrochemische Ätzung von n-dotiertem Silizium zur Herstellung von Löchern oder Gräben ist z. B. aus EP 0 296 348 A1 bekannt, in der Gräben insbesondere für DRAM-Zellen auf diese Weise hergestellt werden. In der älteren deutschen Patentanmeldung P 42 02 455.2 ist vorgeschlagen worden, dieses Ätzverfahren zum Ablösen freitragender Schichten zu verwenden, die als Ausgangsmaterial für die Herstellung von Solarzellen eingesetzt werden. Dabei werden die Solarzellen, wie konventionelle monokristalline Solarzellen, durch Kontakte auf gegenüberliegenden Seiten kontaktiert. Der eine Kontakt ist dabei auf derjenigen Oberfläche angeordnet, durch die der Lichteinfall erfolgt.

Bei der elektrochemischen Ätzung ist die Substratscheibe als Anode verschaltet. Dadurch bewegen sich die Minoritätsladungsträger in dem n-dotierten Silizium zu der mit dem Elektrolyten in Kontakt stehenden Oberfläche. An dieser Oberfläche bildet sich eine Raumladungszone aus. Da die Feldstärke im Bereich von Vertiefungen in der Oberfläche größer ist als außerhalb davon, bewegen sich die Minoritätsladungsträger bevorzugt zu diesen Punkten. Dadurch kommt es zu einer Strukturierung der Oberfläche. Je tiefer eine anfänglich kleine Unebenheit durch die Ätzung wird, desto mehr Minoritätsladungsträger bewegen sich wegen der vergrößerten Feldstärke dorthin und desto starker ist der Ätzangriff an dieser Stelle. Die Löcher wachsen in der kristallographischen 〈100〉-Richtung. Daher ist es vorteilhaft, eine Substratscheibe mit 〈100〉-Orientierung zu verwenden, da dann die Löcher senkrecht zur ersten Oberfläche wachsen. Das führt wiederum zu einer gleichmäßigen Strukturierung der Substratscheibe.

Der Ätzangriff ist abhängig von der Stromdichte in der Substratscheibe und von der Konzentration in dem Elektrolyten. Durch Erhöhung der Stromdichte im Elektrolyten oder durch Verminderung der Konzentration im Elektrolyten wird der Ätzangriff vergrößert. Es liegt im Rahmen der Erfindung, diese Tatsache auszunutzen, um bei Erreichen einer Tiefe der Löcher, die im wesentlichen der Dicke der freitragenden Schicht entspricht, den Ätzabtrag so zu vergrößern, daß der Querschnitt der Locher wächst. Da, wie oben ausgeführt, der Ätzangriff nur im unteren Bereich der Löcher stattfindet, bleibt der Querschnitt der Löcher im oberen Bereich, d. h. in der Nähe der ersten Oberfläche dabei unverändert. Im unteren Bereich jedoch wachsen die Löcher sowohl in die Breite als auch in die Tiefe. Die elektrochemische Ätzung wird solange fortgesetzt, bis benachbarte Löcher zusammenwachsen und dadurch die freitragende Schicht abgelöst wird.

Die freitragende Schicht besteht wie die Substratscheibe aus n-dotiertem, einkristallinem Silizium. Die Dicke der freitragenden Schicht ist über die Tiefe der Löcher einstellbar. Die freitragende Schicht kann in eine Dicke von mindestens 10 µm auf jeden beliebigen Wert der Dicke eingestellt werden. Die freitragende Schicht kann insbesondere gut in einer Dicke von ungefähr 60 µm hergestellt werden, die dem theoretischen Wert für die ideale Dicke bezüglich Wirkungsgrad entspricht.

Nach dem Ablösen der freitragenden Schicht kann auf dieselbe Weise mindestens eine weitere freitragende Schicht von der verbleibenden Substratscheibe durch elektrochemisches Ätzen abgelöst werden. Das Verfahren zum Ahlösen weiterer freitragender Schichten kann so oft wiederholt werden, bis die mechanische Stabilität der verbleibenden Substratscheibe nicht mehr ausreichend ist. Auf diese Weise wird das Material der Substratscheibe wesentlich besser ausgenutzt.

Da die Oberflache der freitragenden Schicht durch den Ätzprozeß rauh ist, ergibt sich eine optische Reflexionsminimierung ohne zusätzliche Prozeßschritte.

Bei der elektrochemischen Ätzung ist die Stromdichte in der Substratscheibe durch Beleuchtung einer der ersten Oberfläche gegenüberliegenden, zweiten Oberfläche der Substratscheibe besonders einfach zu beeinflussen. In diesem Fall wird das Ablösen der freitragenden Schicht durch Vergrößerung der Beleuchtung erzielt.

Es liegt im Rahmen der Erfindung, vor der Bildung der Löcher, die erste Oberfläche der Substratscheibe mit einer Oberflächentopologie zu versehen. Auf diese Weise wird die erste Oberfläche gezielt mit Vertiefungen versehen, an denen der Ätzangriff beim elektrochemischen Ätzen beginnt. Wird die erste Oberflache mit einer Oberflächentopologie aus regelmäßig angeordneten Vertiefungen versehen, zeigt die abgelöste, freitragende Schicht eine im wesentlichen konstante Dicke. In diesem Fall ist nämlich der Abstand der Löcher im wesentlichen gleich, so daß die Materialmenge zwischen benachbarten Löchern, die durch Vergrößerung des Ätzangriffs zum Ablösen der freitragenden Schicht abgeätzt werden muß, im wesentlichen gleich ist. Dann wachsen die Löcher im wesentlichen gleichzeitig zusammen.

Für Anwendungen, bei denen es auf eine konstante Dicke der freitragenden Schicht nicht ankommt, kann die Erzeugung der Oberflächentopologie unterbleiben. Dieses führt zu einer Prozeßvereinfachung.

Die Oberflächentopologie wird dabei z. B. nach Herstellung einer Fotolackmaske auf der ersten Oberfläche und anschließende alkalische Ätzung der ersten Oberfläche erzeugt. Zur Herstellung der Fotolackmaske wird dabei konventionelle optische Fotolithographie verwendet.

Es liegt im Rahmen der Erfindung, die Oberflächentopologie durch lichtinduzierte, elektrochemische Ätzung in demselben Elektrolyten, indem anschließend die Löcher geätzt werden, herzustellen. Dabei wird auf der ersten Oberfläche unter Verwendung einer Lichtquelle mit einer Wellenlänge kleiner als 1100 nm ein Beleuchtungsmuster erzeugt. Die Stromdichte in der Substratscheibe wird so eingestellt, daß nur an belichteten Stellen des Beleuchtungsmusters lokal ein anodischer Minoritätsträgerstrom über die Substratscheibe fließt, der einen Ätzabtrag der ersten Oberfläche bewirkt. Dieses Vorgehen hat den Vorteil, daß zur Erzeugung der Oberflächentopologie keine gesonderte Ätztechnik angewendet werden muß.

Im folgenden wird die Erfindung anhand der Figuren und eines Ausführungsbeispiels genauer erläutert.
- Fig. 1: zeigt eine Substratscheibe mit einer Oberflächentopologie.
- Fig. 2: zeigt eine Draufsicht auf die in Fig. 1 dargestellte Substratscheibe.
- Fig. 3 und Fig. 4: zeigen das Ablösen einer freitragenden Schicht von der Substratscheibe.
- Fig. 5 bis Fig. 11: zeigen das Verfahren zur Herstellung der Solarzelle.

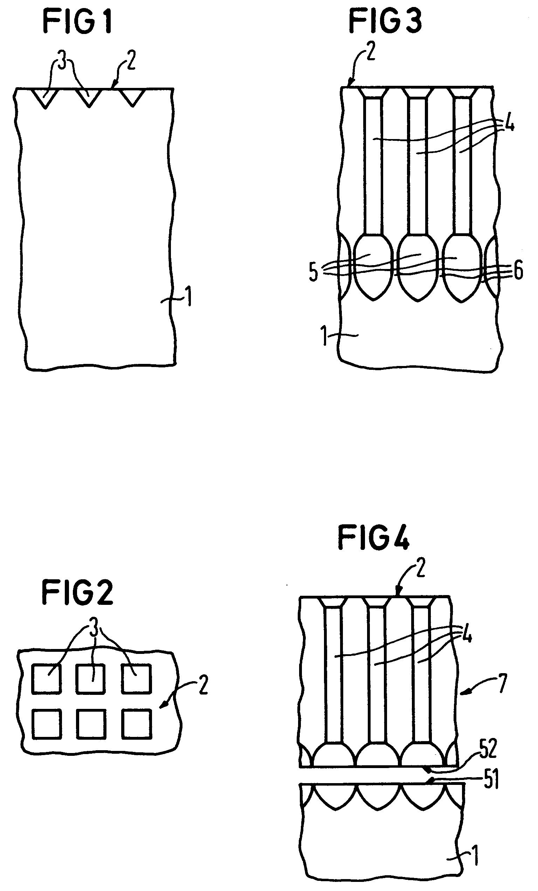

Eine Substratscheibe 1 aus n-dotiertem, einkristallinem Silizium mit z. B. 〈100〉-Orientierung ist in einer ersten Oberfläche 2 mit einer Vertiefungen 3 umfassenden Oberflächentopologie versehen (s. Fig. 1). Die Vertiefungen 3 sind regelmäßig in der ersten Oberfläche 2 angeordnet (s. Draufsicht auf Fig. 1 in Fig. 2).

Die Vertiefungen 3 werden z. B. nach Herstellung einer Fotolackmaske mit Hilfe konventioneller Fotolithographie und anschließender alkalischer Ätzung hergestellt. Alternativ kann die Oberflächentopologie durch lichtinduzierte elektrochemische Ätzung gebildet werden. Nach Herstellung der Vertiefungen 3 wird die erste Oberfläche 2 mit einem Elektrolyten in Kontakt gebracht. Der Elektrolyt ist fluoridhaltig und sauer. Er enthalt eine Flußsaurekonzentration von 1 bis 50 %, vorzugsweise 6 %. Dem Elektrolyten kann ein Oxidationsmittel, z. B. Wasserstoffsuperoxid, zugesetzt werden, um die Entwicklung von Wasserstoffbläschen auf der ersten Oberfläche 2 der Substratscheibe 1 zu unterdrucken. Zwischen die Substratscheibe 1 und den Elektrolyten wird eine Spannung von z. B. 3 Volt angelegt. Dabei wird die Substratscheibe 1, die z. B. eine Leitfähigkeit von 5 Ohm cm aufweist, als Anode verschaltet. Die Substratscheibe 1 wird von einer, der ersten Oberfläche gegenüberliegenden zweiten Oberfläche her beleuchtet. Durch die Beleuchtung wird in der Substratscheibe 1 eine Stromdichte von 10 mA/cm² eingestellt.

Mit diesen Prozeßparametern werden Löcher 4 in die erste Oberfläche 2 geätzt (s. Fig. 3). Die Löcher 4 verlaufen senkrecht zur ersten Oberfläche 2. Sie weisen einen über ihre Tiefe konstanten Querschnitt parallel zur ersten Oberfläche 2 auf. Der Querschnitt der Löcher 4 ist abhängig von der Stromdichte in der Substratscheibe 1 und der Fluoridkonzentration des Elektrolyten.

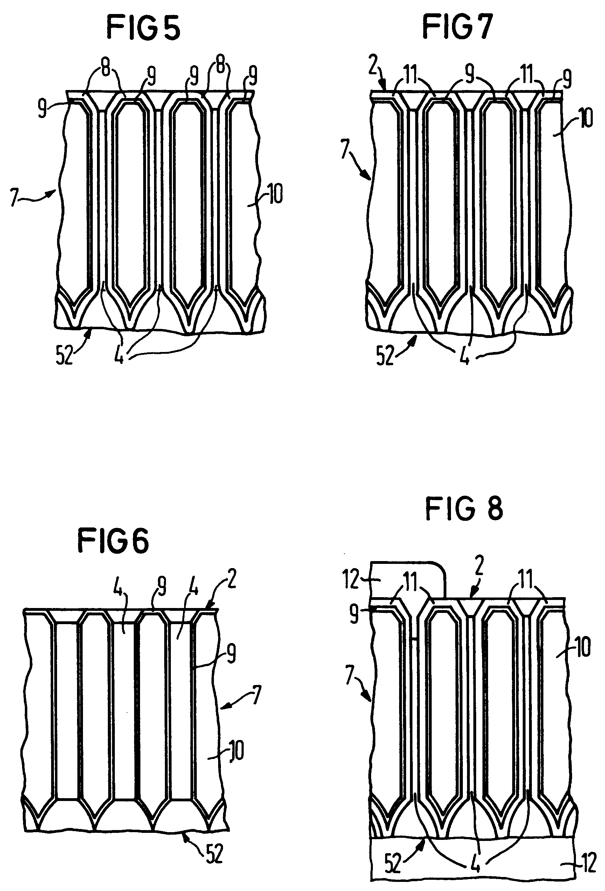

Nach einer Ätzzeit von 60 Minuten wird mit den obengenannten Prozeßparametern eine Tiefe der Löcher 4 von etwa 30 µm erreicht. Bei dieser Tiefe wird die Stromdichte in der Substratscheibe 1 auf z. B. 30 mA/cm² erhöht. Dabei wird die Spannung zwischen der Substratscheibe 1 und dem Elektrolyten auf 2 Volt eingestellt. Die Substratscheibe 1 wird weiterhin von der zweiten Oberfläche her beleuchtet. Durch diese veränderten Prozeßparameter entstehen am Boden der Löcher 4 höhlenförmige Erweiterungen 5, weil die Stromdichte vergrößert wurde. Benachbarte höhlenförmige Erweiterungen 5 werden durch Stege 6 getrennt. Die Breite der Stege 6 nimmt während der Ätzung ab. Nach etwa 10 Minuten sind mit den angegeben Prozeßparametern die Stege 6 weggeätzt, und die höhlenförmigen Erweiterungen 5 und damit die Löcher 4 wachsen zusammen (s. Fig. 4).

Dadurch wird die freitragende Schicht 7 von dem Rest der Substratscheibe 1 abgelost. Die freitragende Schicht 7 umfaßt die erste Oberfläche 2 und die Löcher 4. An der der ersten Oberfläche 2 abgewandten Seite weist die freitragende Schicht, bedingt durch das Zusammenwachsen der höhlenförmigen Erweiterungen 5 der Löcher 4 eine strukturierte Oberfläche 52 auf.

Der Rest der Substratscheibe 1 weist ebenfalls eine strukturierte Oberfläche 51, als Folge des Zusammenwachsens der höhlenförmigen Erweiterungen 5, auf. Die strukturierte Oberfläche 51 ist daher, bedingt durch ihre Entstehung, mit einer Oberflächentopologie versehen. Diese Oberflächentopologie entspricht der Anordnung der Vertiefungen 3 zu Beginn der Bearbeitung der Substratscheibe 1 (vgl. Fig. 1). Ausgehend von der Substratscheibe 1 mit der strukturierten Oberfläche 51 kann durch elektrochemische Ätzung eine weitere freitragende Schicht abgelost werden. Dieses ist solange möglich, wie es die mechanische Stabilität des Restes der Substratscheibe erlaubt. Die Grenze liegt bei einer Dicke des Restes der Substratscheibe 1 von 100 bis 200 µm.

Aus der freitragenden Schicht 7 wird eine Solarzelle hergestellt. Fur die Herstellung der Solarzelle ist es wichtig, daß die freitragende Schicht 7 durchgehende Löcher 4 aufweist. Als Ausgangsmaterial zur Herstellung der Solarzelle ist es daher auch möglich, eine freitragende Schicht zu verwenden, die aus einer Substratscheibe besteht, in der durchgehende Löcher hergestellt sind. Es ist nicht erforderlich, daß die freitragende Schicht 7 durch Ablösen hergestellt wird. Es ist jedoch vorteilhaft, die freitragende Schicht 7 durch Ablösen in der beschriebenen Weise herzustellen, da in diesem Fall die Dicke der Solarzelle auf den optimalen, theoretischen Wert eingestellt werden kann.

Zur Herstellung der Solarzelle wird auf die gesamte Oberfläche der freitragenden Schicht 7 eine Schicht 8 aus Borphosphorsilikatglas (BPSG) aufgebracht. Die Schicht 8 bedeckt auch die Oberflächen der Locher 4 (s. Fig. 5). Durch Ausdiffusion von Bor aus der Schicht 8 aus BPSG wird ein p⁺-dotierter Bereich 9, der an der gesamten Oberfläche der freitragenden Schicht 7 angeordnet ist, gebildet. Die Dotierung in dem p⁺-dotierten Bereich 9 wird z. B. auf 10¹⁹ pro cm³ eingestellt. Im Inneren der freiliegenden Schicht 7 verbleibt ein n-dotierter Bereich 10. In den n-dotierten Bereich 10 liegt dieselbe Dotierstoffkonzentration wie in der Substratscheibe 1 vor, z. B. 5 Ohm cm.

Anschließend wird die Schicht 8 aus BPSG entfernt (s. Fig. 6). Die Oberfläche der freitragenden Schicht 7 wird anschließend z. B. thermisch oxidiert, so daß eine SiO₂-Schicht 11 entsteht, die die gesamte Oberfläche der freitragenden Schicht, auch der Löcher 4, bedeckt (s. Fig. 7).

Anschließend wird eine Positiv-Fotolackschicht 12 aufgebracht, die sowohl die erste Oberfläche 2 als auch die strukturierte Oberfläche 52 bedeckt. Die Positiv-Fotolackschicht 12 wird belichtet und entwickelt, wobei ein Teil der ersten Oberfläche 2 freigelegt wird durch Entfernen des Fotolacks bei der Entwicklung (siehe Figur 8). In dem von der Fotolackschicht nicht bedeckten Teil der ersten Oberfläche 2 wird im Folgenden ein Kontakt zu dem n-dotierten Gebiet 10 hergestellt.

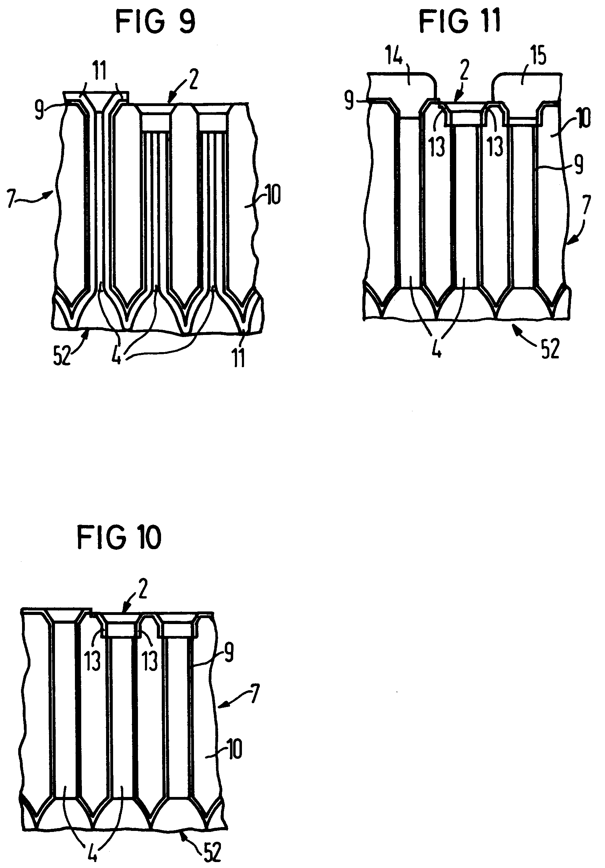

Unter Verwendung der Fotolackschicht 12 als Maske wird der freiliegende Teil der SiO₂-Schicht 11 abgeätzt. Nach Entfernen der Fotolackschicht 12 (s. Fig. 9) wird unter Verwendung der strukturierten SiO₂-Schicht 11 als Maske der freiliegende Teil des p-dotierten Gebietes 9 entfernt. Dadurch wird in dem Teil der ersten Oberfläche 2, in dem ein Kontakt zu dem n-dotierten Gebiet 10 hergestellt werden soll, die Oberfläche des n-dotierten Gebietes 10 freigelegt.

Unter Verwendung der strukturierten SiO₂-Schicht 11 als Maske wird z. B. durch Implantation mit Arsen an der Oberfläche des freiliegenden n-dotierten Gebietes 10 ein n⁺-dotiertes Gebiet 13 hergestellt. In dem n⁺-dotierten Gebiet 13 wird eine Dotierstoffkonzentration von z. B. 10²⁰ cm⁻³ eingestellt. Nach Entfernen der strukturierten SiO₂-Schicht 11 (s. Fig. 10) werden auf die erste Oberfläche 2 ein erster Kontakt 14 und ein zweiter Kontakt 15 z. B. durch Bedrucken mit Silberleitpaste hergestellt. Der erste Kontakt 14 ist dabei in dem Teil der ersten Oberfläche 2 angeordnet, in dem das p-dotierte Gebiet 9 an die Oberfläche angrenzt. Der zweite Kontakt 15 ist in dem Teil der ersten Oberfläche 2 angeordnet, in dem durch Abätzen des p-dotierten Bereichs 9 und durch Implantation das n⁺-dotierte Gebiet an die erste Oberfläche 2 angrenzt. Damit wird das p-dotierte Gebiet 9 von dem ersten Kontakt 14 kontaktiert, wahrend das n-dotierte Gebiet 10 über den zweiten Kontakt 15 kontaktiert wird (s. Fig. 11).

In dieser Solarzelle fällt die erste Hauptfläche mit der ersten Oberfläche 2 zusammen. Die zweite Hauptfläche, durch die der Lichteinfall in die Solarzelle erfolgt, fällt mit der strukturierten Oberfläche 52 zusammen. Das erfindungsgemäße Herstellverfahren kann analog ausgeführt werden, wenn die strukturierte Oberfläche 52 als erste Hauptfläche verwendet wird und die erste Oberfläche 2 als zweite Hauptfläche.

Durch Anordnung beider Kontakte auf der im Betrieb der Solarzelle Rückseite der Solarzelle wird eine Abschattung der Solarzellen vermieden. Damit können die Kontakte so ausgeführt werden, daß die ohmschen Verluste minimiert werden. Ferner kann eine Verschaltung der Solarzellen von der Rückseite her erfolgen.

Die Elastizität der freitragenden Schicht erlaubt überdies eine flächenfüllende Verlegung der Solarzellen auf einem mit Leiterbahnen versehenen, nicht ebenen Träger.

## Patentansprüche

1. Verfahren zur Herstellung einer Solarzelle aus einer Substratscheibe,
- bei dem in einer Substratscheibe (1) aus n-dotiertem, monokristallinem Silizium durch elektrochemisches Ätzen in einer ersten Oberfläche (2) durchgehende Löcher (4) gebildet werden, so daß eine perforierte, freitragende Schicht (7) aus n-dotiertem, monokristallinem Silizium entsteht,
- bei dem zur Bildung eines pn-Übergangs in der freitragenden Schicht mindestens ein n-dotiertes Gebiet (10) und ein p-dotiertes Gebiet (9) hergestellt werden, die beide an eine erste Hauptfläche (2) der freitragenden Schicht angrenzen, wobei die erste Hauptfläche (2) parallel zur ersten Oberfläche (2) angeordnet ist,
- bei dem auf der ersten Hauptfläche (2) ein Kontakt (15) zu dem n-dotierten Gebiet (13, 10) und ein Kontakt (14) zu dem p-dotierten Gebiet (9) gebildet wird, so daß der pn-Übergang als Solarzelle verschaltbar ist, in die der Lichteinfall über eine zweite, der ersten gegenüberliegende Hauptfläche (52) erfolgen kann.

2. Verfahren nach Anspruch 1,
bei dem die freitragende Schicht (7) dadurch gebildet wird,
- daß in der ersten Oberfläche (2) der Substratscheibe (1) durch elektrochemisches Ätzen Löcher (4) gebildet werden,
- daß bei Erreichen einer Tiefe der Löcher (4) die im wesentlichen der Dicke der freitragenden Schicht (7) entspricht, die Prozeßparameter der Ätzung so geändert werden, daß der Querschnitt der Löcher (4) wächst und daß die freitragende Schicht (7) durch Zusammenwachsen der Locher (4) abgelost wird.

3. Verfahren nach Anspruch 1,
bei dem die elektrochemische Ätzung in einem fluoridhaltigen, sauren Elektrolyten durchgeführt wird, mit dem die erste Oberfläche in Kontakt steht und zwischen den und die Substratscheibe eine elektrische Spannung so angelegt wird, daß die Substratscheibe als Anode verschaltet ist und daß in der Substratscheibe eine den Ätzabtrag beeinflussende Stromdichte eingestellt wird.

4. Verfahren nach einem der Ansprüche 1 bis 3,
bei dem die Löcher (4) senkrecht zur ersten Oberfläche (2) gebildet werden.

5. Verfahren nach einem der Ansprüche 1 bis 4,
bei dem die Substratscheibe eine 〈100〉-Scheibe ist.

6. Verfahren nach einem der Ansprüche 1 bis 5,
bei dem die Substratscheibe durch eine der ersten Oberfläche gegenüberliegende, zweite Oberfläche beleuchtet wird, um die Stromdichte in der Substratscheibe einzustellen.

7. Verfahren nach einem der Ansprüche 1 bis 6,
bei dem an der ersten Oberfläche der Substratscheibe vor der Bildung der Löcher eine Oberflächentopologie erzeugt wird, die die Anordnung der Löcher bestimmt.

8. Verfahren nach Anspruch 7,
bei dem die Oberflächentopologie aus regelmäßig angeordneten Vertiefungen der Oberfläche besteht.

9. Verfahren nach Anspruch 7 oder 8,
bei dem die Oberflächentopologie durch Herstellung einer Fotolackmaske auf der ersten Oberfläche der Substratscheibe und anschließende alkalische Ätzung der ersten Oberfläche der Substratscheibe erzeugt wird.

10. Verfahren nach Anspruch 7 oder 8,
bei dem die Oberflächentopologie durch elektrochemisches Ätzen in einem Elektrolyten dadurch erzeugt wird, daß auf der ersten Oberfläche unter Verwendung einer Lichtquelle mit einer Wellenlänge kleiner als 1100 nm ein Beleuchtungsmuster erzeugt wird und daß die Stromdichte in der Substratscheibe so eingestellt wird, daß nur an belichteten Stellen des Beleuchtungsmusters lokal ein anodischer Minoritätsträger Strom über die Substratscheibe fließt, der einen Ätzabtrag der ersten Oberfläche bewirkt.

11. Verfahren nach einem der Ansprüche 1 bis 10,
bei dem der Elektrolyt 1 bis 50 % Flußsäure (HF) enthält.

12. Verfahren nach Anspruch 11,
bei dem der Elektrolyt zusätzlich ein Oxidationsmittel enthält.

13. Verfahren nach einem der Ansprüche 1 bis 12,
bei dem zum Ablosen der freitragenden Schicht die Stromdichte in der Substratscheibe erhöht wird.

14. Verfahren nach einem der Ansprüche 1 bis 12,
bei dem zum Ablösen der freitragenden Schicht die Konzentratoin des Fluorid im Elektrolyten reduziert wird.

15. Verfahren nach einem der Ansprüche 1 bis 14,
- bei dem zur Herstellung des pn-Übergangs die gesamte Oberfläche der freitragenden Schicht p⁺-dotiert wird, während das n-dotierte Gebiet das Innere der freitragenden Schicht (7) umfaßt,
- bei dem eine Maske erzeugt wird, die bis auf einen Teil der ersten Hauptfläche, in dem das n-dotierte Gebiet an die erste Hauptfläche angrenzen soll, die gesamte Oberfläche der freitragenden Schicht bedeckt,
- bei dem durch Abätzen der von der Maske unbedeckten p⁺-dotierten Oberfläche die Oberfläche des n-dotierten Gebietes freigelegt wird,
- bei dem nach Entfernen der Maske das p⁺-dotierte Gebiet und das freigelegte n-dotierte Gebiet an der ersten Hauptfläche (2) mit jeweils einem Kontakt (14, 15) versehen werden.

16. Verfahren nach Anspruch 15,
bei dem vor dem Entfernen der Maske die freigelegten Teile des n-dotierten Gebietes (10) mit einer n⁺-Dotierung (13) versehen werden.

17. Verfahren nach Anspruch 15 oder 16,
bei dem die freitragende Schicht (7) mit einer Schicht aus Borphosphorsilikatglas überzogen wird, die die gesamte Oberfläche der freitragenden Schicht bedeckt, und bei dem durch Ausdiffusion von Bor aus der Schicht aus Borphosphorsilikatglas die Oberfläche der freitragenden Schicht p⁺-dotiert wird.

18. Verfahren nach einem der Ansprüche 15 bis 17,
bei dem zur Herstellung der Maske die gesamte Oberfläche der freitragenden Schicht mit einer SiO₂-Schicht (11) versehen wird,
- bei dem die SiO₂-Schicht (11) auf der ersten Hauptfläche (2) und der zweiten Hauptfläche (52) mit Positiv-Fotolack (12) versehen wird,
- bei dem der Positiv-Fotolack (12) so belichtet wird, daß der Positiv-Fotolack (12) beim Entwickeln in dem Teil der ersten Hauptfläche (2) entfernt wird, in dem das n-dotierte Gebiet (10) an die erste Hauptfläche angrenzen soll,
- bei dem unter Verwendung des entwickelten Positiv-Fotolacks (12) als Ätzmaske der freiliegende Teil der SiO₂-Schicht (11) entfernt wird, so daß in diesem Bereich die p⁺-dotierte Oberfläche (9) der freitragenden Schicht (7) freigelegt wird.
